# EUROPÄISCHE PATENTSCHRIFT

(11) **EP 0 373 412 B1**
(45) Veröffentlichungstag und Bekanntmachung des Hinweises auf die Patenterteilung: **17.05.1995**
(21) Anmeldenummer: 89121871.1
(22) Anmeldetag: 27.11.1989
(51) Int. Cl.: C23C 16/30, C23C 16/52, B32B 15/01

(54) **Verfahren zur Beschichtung eines Werkzeuggrundkörpers und nach diesem Verfahren hergestelltes Werkzeug**
Process for coating tools, and tool produced thereby
Procédé de revêtement d'un outil et outil produit par ce procédé

(30) Priorität: 10.12.1988 DE 3841731; 21.08.1989 DE 8909928 U; 22.08.1989 DE 8910041 U
(43) Veröffentlichungstag der Anmeldung: 20.06.1990
(73) Patentinhaber: Widia GmbH, 45145 Essen (DE)
(72) Erfinder: Van den Berg, Hendrikus, Dr. rer. nat. Dipl.-phys., NL-5925 BT Venlo-Blerick (NL); König, Udo, Dr. rer. nat. Dipl.-phys, D-4300 Essen 1 (DE); Tabersky, Ralf, Dipl.-phys., D-4250 Bottrop (DE); Blum, Josef, Dipl.-Ing., D-4300 Essen 13 (DE)
(74) Vertreter: Vomberg, Friedhelm, Dipl.-Phys.

(56) Entgegenhaltungen:
- EP-A- 0 196 201
- EP-A- 0 199 527
- DE-U- 8 514 257
- GB-A- 2 194 556
- US-A- 4 748 451
- "EURO CVD FOUR", PROCEEDINGS OF THE FOURTH EUROPEAN CONF. ON CVD, MAY 31-JUNE 2, 1983, SEITEN 468-473.
- 12TH INT. PLANSEE SEMINAR '89, PROCEEDINGS, VOL.3, SEITEN 13-25, MAY 8-12, 1989.

## Beschreibung

Die Erfindung betrifft ein Verfahren zur Beschichtung eines Werkzeuggrundkörpers, vorzugsweise aus Hartmetall oder Stahl, mit Carbiden, Nitriden und/oder Carbonitriden von Titan und/oder Zirkonium mittels eines Plasma-CVD-Verfahrens. Die Erfindung betrifft ferner ein nach diesem Verfahren hergestelltes Werkzeug, bestehend aus einem Grundkörper und mindestens einer aus Carbiden, Nitriden und/oder Carbonitriden von Titan aufgebauten Oberflächenschicht, die mittels eines plasmaaktivierten CVD-Verfahrens unter Einsatz von Titantetrachlorid in der Gasphase aufgebracht ist.

Bereits in der DE-Z "Angewandte Chemie", 69. Jahrgang, Nr. 9, Seite 281 bis 312, 07. Mai 1957, wird beschrieben, daß die Sprödigkeit von Hartstoffen dadurch umgangen werden kann, daß man dieselben in Form von dünnen Oberflächenschichten anwendet, um andere Werkstoffe gegen mechanische oder chemische Beanspruchung zu schützen. So wird beispielsweise die Beschichtung eines Bleches mit einer 6 »m starken Schicht von TiN beschrieben.

Darüber hinaus ist beispielsweise aus der CH-PS 507 094 ein Formkörper bekannt, der aus einer Hartmetallunterlage und mindestens einer Hartstoffschicht besteht, wobei die Hartmetallunterlagen aus einem oder mehreren Hartstoffen und mindestens einem Bindemetall zusammengesetzt ist, und wobei die Hartstoffschicht harte Carbide oder Nitride enthält. Derartige Formkörper können für Werkzeuge der spanabhebenden und spanlosen Formgebung verwendet werden, da sie gute Verschleißeigenschaften besitzen. Die Körper werden nach dem CVD-Prozeß (chemical vapour deposition-Prozeß) hergestellt, wie er beispielsweise in der CH-PS 452 205 beschrieben ist. Der CVD-Prozeß gehört heute zu den gebräuchlichsten Beschichtungsverfahren und besteht darin, daß aus einer reaktiven Gasatmosphäre, die in der Regel eine Temperatur zwischen 900 bis 1200 °C hat, auf einem Substrat eine Oberflächenschicht abgeschieden wird. Dabei enthält die Gasatmosphäre mehrere Verbindungen, die bei der Reaktionstemperatur miteinander reagieren und den in der Oberflächenschicht vorhandenen Stoff bilden. Es ist heute allgemein üblich, metallische Substrate mit Hartstoffschichten aus Carbiden, Nitriden oder Carbonitriden zu überziehen, wobei die Gesamtatmosphäre Halogenide der Elemente der III.- bis VI.-Gruppe des Periodensystems und eine stickstoffhaltige Verbindung und eine kohlenstoffhaltige Verbindung enthalten. So wird auf einem Hartmetallgrundkörper eine Titancarbidschicht bei ca. 1000 °C aus einer Gasatmosphäre abgeschieden, die Titantetrachlorid und Methan enthält. Als kohlenstoffhaltige Verbindungen werden insbesondere gasförmige Kohlenwasserstoffe verwendet, während als stickstoffhaltige Verbindungen N₂, NH₃ oder Amine zur Anwendung kommen. Die hohen Beschichtungstemperaturen von ca. 1000 °C verursachen jedoch Zähigkeitsverluste des Verbundkörpers.

In der DE-Z "VDI-Z" 124 (1982), Nr. 18, September (II), Seite 693 ff. wird ferner das Aufbringen verschleißfester Schichten auf Werkzeugstahl nach dem CVD-Verfahren beschrieben. Als Nachteil wird auch hier wieder angesehen, daß das zu beschichtende Werkzeug relativ lange auf hoher Temperatur bleiben muß, so daß die Gefahr von Kornwachstum im Stahl sowie einer Stabilisierung der Austenit-Phase (der Hochtemperaturphase von Stahl, die durch Abkühlung in die Martensit-Phase übergehen soll). Nach Ablauf des CVD-Prozesses wird der Reaktor unter Wasserstoff mit einer Abkühlrate von 20 bis 50 °C/min abgekühlt, was zur Folge hat, daß Stahlsorten, die durch Abschrecken in Wasser oder Öl härten, bei weitem nicht ihre maximale Härte erreichen. Auch dieses spricht dafür, daß die hohen CVD-Abscheidetemperaturen unerwünschte Nebeneffekte haben.

Um eine niedrigere Abscheidetemperatur zu erhalten, ist daher das sogenannte plasmaunterstützte CVD-Verfahren vorgeschlagen worden. In einem Plasma einer Niederdruckglimmentladung besteht die Gasmischung aus Neutralteilchen, Molekülen, dissoziierten Molekülen, Ionen und Elektronen. Wegen des Ungleichgewichtszustandes bei der Niederdruckentladung sind die Temperaturen der Elektronen einige tausend Grad höher als die der schweren Teilchen (Ionen, Neutralteilchen). Hierdurch werden chemische Reaktionsprozesse (auch unterhalb der sonst im CVD-Prozeß notwendigen 1000 °C) aktiviert. Ein Niederdruckplasma kann beispielsweise durch eine Gleichspannung oder durch eine hochfrequente Wechselspannung bei Drücken zwischen 10 und 1000 Pascal erzeugt werden. Der einfachste Weg, eine Niederdruckentladung zu erzeugen, besteht darin, das zu beschichtende Werkstück mit der Kathode zu verbinden und die Rezipientenwände als Anode zu schalten.

Das aufwendigere Hochfrequenzverfahren kann hingegen elektrodenlos betrieben werden. Vorteilhafterweise können mit diesem Verfahren sowohl metallische wie auch nichtmetallische Grundkörper beschichtet werden. Die Substrattemperatur ist eine Funktion der eingebrachten Hochfrequenzenergie. Allerdings ist dieses Verfahren sehr aufwendig und relativ kostspielig.

Ferner wird in der EP 0 199 527 A1 ein Plasma-CVD-Verfahren beschrieben, bei dem an das zu beschichtende Substrat eine negative, das Plasma anregende Gleichspannung bis zu 1500 V angelegt wird, der eine Hochfrequenzspannung mit z.B. 13,56 MHz überlagert wird.

In der DE 30 27 688 B1 wird ein Verfahren beschrieben, bei dem im Anschluß an eine Oberflächenbeschichtung an den Verbundkörper in einer Inertgasatmosphäre bei einem Druck von 10⁻² bis 10² mbar und einer Temperatur von 200 bis 800 °C eine negative Gleichspannung angelegt wird, die zur Aufrechterhaltung einer mindestens 10-minütigen Glimmentladung ausreicht.

Die DE-A-601 847 beschreibt ein Verfahren zur Vergütung von Metallen, insbesondere Karborierung von Eisen bzw. Wolfram im Teilvakuum, bei dem die Glimmentladung eine schlagartige Entladung eines kapazitiven Energiespeichers ist, also durch kurzzeitige Stoßspannungsimpulse erzeugt wird, bei denen die Impulsdauer etwa 10⁻⁵ bis 10⁻⁶ sec. beträgt. Die Pausen zwischen den einzelnen Stoßimpulsen werden mindestens 10mal so groß gewählt wie die Impulsdauer selbst, damit in der Zwischenzeit eine Entionisierung der Gasstrecke eintreten kann.

Es ist Aufgabe der vorliegenden Erfindung, das eingangs genannten CVD-Verfahren dahingehend zu verbessern, daß hohe Beschichtungstemperaturen vermieden werden, ferner soll eine möglichst kurze Beschichtungszeit bei niedrigen Betriebskosten erreicht werden.

Es ist ferner Aufgabe der vorliegenden Erfindung, ein beschichtetes Werkzeug der eingangs genannten Art zu schaffen, dessen Oberflächenbeschichtung gleichmäßig ist und gut haftet.

Die Aufgabe wird durch ein Verfahren mit den im Anspruch 1 dargelegten Merkmalen gelöst. Wesentliches Merkmal dieses Verfahrens ist eine gepulste Gleichspannung mit einer in den Pulspausen verbleibenden Restgleichspannung einer Größe gleich oder oberhalb des niedrigsten Ionisierungspotentials der beteiligten Gase CVD-Prozesses. Diese Restgleichspannung sollte jedoch 50 % des Maximalwertes der gepulsten Gleichspannung nicht überschreiten.

Die gepulste Gleichspannung ist im Regelfall eine Rechteckspannung mit einer maximalen Amplitude zwischen 200 und 900 Volt und einer Periodendauer zwischen 20 »s und 20 ms. Abweichungen unter Ausbildung von nicht senkrechten Anstiegs- und Abfallflanken sowie Dachschrägen sind jedoch ebenso denkbar, sofern die Bedingung erfüllt bleibt, daß zwischen zwei maximalen Spannungswerten die Gleichspannung nicht auf Null sinkt, sondern stets oberhalb des niedrigsten Ionisierungspotentials der beteiligten Gase und unterhalb von 50 % der maximalen Spannungsauslenkung bleibt. Vorzugsweise wird ein Verhältnis der (mittleren) Restgleichspannung zur maximalen gepulsten Gleichspannung zwischen 0,02 und 0,5 eingestellt. Nach einer Weiterbildung der Erfindung liegt das Verhältnis der Pulslänge (Dauer des positiven Spannungssignals eines Pulses) zu der zwischen zwei Pulsen liegenden Pulspause zwischen 0,1 bis 0,6. Bei Abscheidetemperaturen zwischen 400 und 600 °C sollte die Schichtwachstumsgeschwindigkeit zwischen 0,5 bis 10 »m/h liegen.

Anders als die bekannten Niedertemperaturbeschichtungsverfahren, wie Magnetron-Kathodenzerstäubung, Ion-Plating und Bogenverdampfung, die in Druckbereich arbeiten, bei denen eine weitgehend geradlinige Ausbreitung der reaktiven Spezies erfolgt, wodurch Abschattungseffekte auftreten, kann nach der vorliegenden Erfindung ein CVD-Niedertemperaturverfahren mit einer einfachen Chargierung bei allseitig guter Beschichtung verwendet werden. Zur Erzeugung der Niederdruckglimmentladung wird ein Pulsgenerator verwendet, der eine weitgehende Entkopplung von Plasmaparametern und Substrattemperatur ermöglicht. Die gepulste Gasentladung reduziert die Gefahr von Bogenentladungen bei hohen Strömen bzw. Spannungen erheblich, so daß mit einer geeigneten Überwachung eine Schnellabschaltung eine Schädigung der Substrate verhindert. In den Pulspausen bleibt jedoch eine Gleichspannung aufrechterhalten, die mindestens so groß ist wie das niedrigste Ionisierungspotential der am CVD-Prozeß beteiligten Gasmoleküle. Der maximale Wert der Restgleichspannung beträgt 50 % des Maximalwertes der gepulsten Spannung. Die Ionisierungspotentiale der maßgeblichen Gasmoleküle sind im einzelnen im folgenden angegeben:
H : 13,6 eV, H₂ : 15,8 eV, N : 14,5 eV, N₂ : 15,7 eV, Ar : 15,7 eV, Ti : 13,57 eV.

Die Aufgabe wird ferner durch ein Werkzeug mit den in dem Anspruch 8 aufgeführten Merkmalen gelöst; Weiterbildungen der Erfindung sind in den Ansprüchen 9 bis 18 aufgeführt.

Als besonders verschleißfest aber auch mit einer hinreichenden Härte hat sich die Oberflächenschichtfolge TiN-Schicht, ein oder mehrere Ti(C,N)-Schicht(en), TiN-Schicht erwiesen. Insbesondere werden Werkzeuggrundkörper aus WC mit 6 Massen % Binder, vorzugsweise Co, vorgeschlagen. Nach einer Weiterbildung der Erfindung können bis zu 30 % des WC durch TiC, TaC und/oder NbC ersetzt sein. Es hat sich bereits als ausreichend erwiesen, wenn keine der Schichten dicker als 5 »m ist.

Die Erfindung betrifft als Werkzeug beispielsweise ein Kreisschermesser, insbesondere Obermesser zum Schneiden von Magnetbändern aus Kunststoff, wie Polyester, der mit einer Schicht aus Eisenoxid und/oder Chromoxid beschichtet und zum Einspeichern von Ton- oder Videosignalen geeignet ist, bestehend aus einem ringförmigen flachen Hartmetallkörper, der mit mindestens einer aus Carbiden, Nitriden und/oder Carbonitriden des Titans bestehenden, gleichmäßig planparallelen Oberflächenschicht einer Dicke zwischen 1 bis 4 »m überzogen ist, wobei die Abweichung von der Planparallelität der Oberflächenschicht < 0,003 mm und/oder die Rauheit R_{Z} < 0,08 »m betragen.

Die Magnetbänder gehören zu den sogenannten bewegten Schichtspeichern und sind z.B. mit einer Schicht nadelförmiger Eisenoxidkristalle versehen. Das Einspeichern der elektrischen Signale besteht im gerichteten Aufmagnetisieren der Nadeln, indem der Träger mit konstanter Geschwindigkeit an einem elektromagnetischen Wandler, dem sogenannten Magnetkopf vorbeigeführt wird.

Die Magnetbänder werden aus relativ breiten Folien mittels kantenversetzt laufenden Messern geschnitten. Durch ihren Gehalt an Ferritpulver wirkt das Tonbandmaterial stark verschleißend. Daher hat man bereits vorgeschlagen, Kreisschermesser aus Wolframcarbid-Hartmetall mittlerer Korngröße mit 6 bis 15 % Cobalt zu verwenden (vgl. "Hartmetall für den Praktiker", Dr. W. Schedler, VDI-Verlag GmbH, 1988, S. 494). Dennoch verschleißen diese Messer relativ schnell und müssen häufig an der Umfangfläche nachgeschärft werden, was jedesmal ein Auswechseln der Messer bedingt.

Nach dem Stand der Technik bekannte Beschichtungen auf Blechen oder aber auch relativ großen unflexiblen Hartmetallformkörpern können in der Regel nach dem PVD- oder dem CVD-Verfahren aufgebracht werden. Eine PVD-Beschichtung bei Kreisschermessern ist jedoch nur von einer Seite möglich, dazu ist die mittels eines PVD-Verfahrens aufgetragene Oberflächenschicht uneben und weist eine hohe Druckeigenspannung auf, so daß das Messer verformt und unbrauchbar wird.

Die beim nach dem Stand der Technik bekannten CVD-Prozeß bisher benötigten hohen Beschichtungstemperaturen von ca. 1000 °C bewirken eine Verformung der dünnen Kreisschermesser und verursachen darüber hinaus einen Verlust an Zähigkeit des Verbundkörpers, der sich in einer erhöhten Bruchanfälligkeit äußert. Auch solche Kreisschermesser sind unbrauchbar.

Vorzugsweise wird die Oberflächenschicht eine Dicke von 2 bis 3 »m haben.

Die erfindungsgemäßen Kreisschermesser besitzen vorteilhafterweise einen Hartmetallkörper mit einer Dicke zwischen 0,4 und 0,8 mm, vorzugsweise zwischen 0,5 und 0,6 mm, der weiterhin vorzugsweise einen Außendurchmesser zwischen 80 und 150 mm, vorzugsweise zwischen 100 und 125 mm, und/oder eine zentrale Bohrung mit einem Durchmesser von 50 bis 80 mm, vorzugsweise 60 bis 70 mm, aufweist.

Die Kreisschermesser können in einer Nebeneinanderordnung von bis zu 60 Messern auf einer Welle angeordnet und zusammen mit betreffenden Untermessern zum Schneiden von Kunststoffolien, insbesondere Magnetbändern, verwendet werden.

Als Material für den Hartmetallkörper wird Wolframcarbid mit 6 bis 25 Massen-% Cobalt, vorzugsweise 9 bis 15 Massen-% Cobalt als Binder, vorgeschlagen, wobei der Hartmetallkörper bis zu 30 Massen-% Titan-, Tantal- und/oder Niobcarbid enthalten kann. Der Chlorgehalt in der bzw. den Oberflächenschicht(en) beträgt nach einer weiteren Ausbildung der Erfindung zwischen 0,5 und 4 Massen-%. Will man eine Mehrfachbeschichtung aufbringen, so hat sich insbesondere die Schichrfolge Titannitrid, Titancarbonitrid und Titannitrid als günstig erwiesen.

Weitere Vorteile der Erfindung werden anhand der Ausführungsbeispiele und der Zeichnungen beschrieben. Es zeigen
- Fig. 1: einen Querschnitt durch eine Titannitridbeschichtete Hartmetall-Ringplatte,
- Fig. 2: eine Schneidanordnung mit mehreren auf Wellen angeordneten Kreisschermessern,
- Fig. 3: den elektrischen Spannungsverlauf zur Erzeugung der Glimmentladung am zu beschichtenden Hartmetallkörper und
- Fig. 4 und 5: jeweils graphische Darstellungen der Ergebnisse von durchgeführten Frästesten.

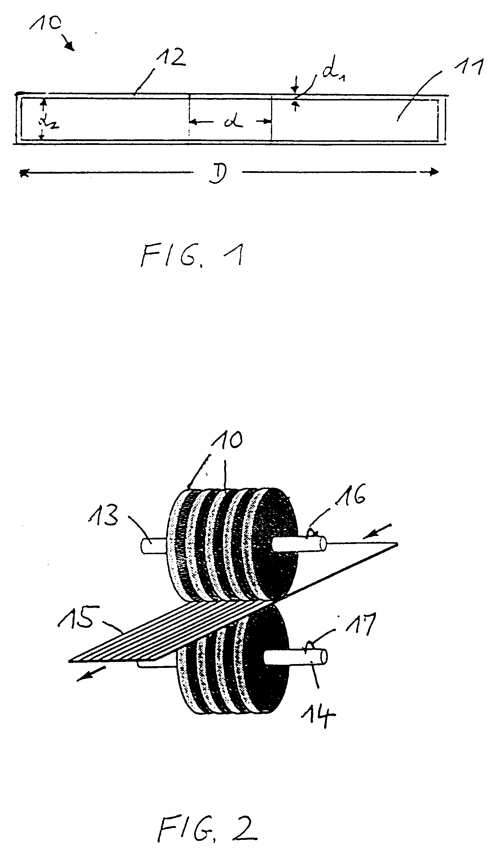

Das in Fig. 1 dargestellte Kreisschermesser besteht aus einem ringförmigen flachen Hartmetallkörper 11 der Zusammensetzung 78,5 Massen-% WC, 10 % (Ti,Ta,Nb)C, 11,5 % Co, der mit einer ca. 1,5 »m dicken Titannitridschicht 12 überzogen ist, die durch das im folgenden beschriebene Verfahren aufgetragen worden ist. Die Dicke d₂ des Hartmetallkörpers beträgt 0,5 mm plus 1,5 »m Schichtdicke d₁ bei einem Außendurchmesser D von 106,5 mm und einem Innendurchmesser d von 70 mm.

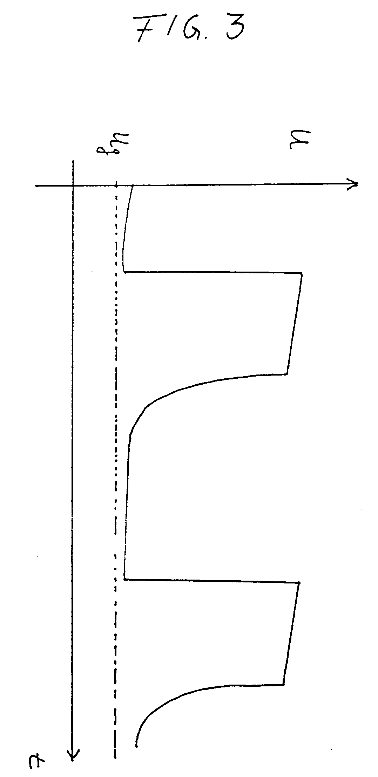

Zur Beschichtung wird eine gepulste Gleichspannung in einem plasmaunterstützten CVD-Prozeß verwendet, die im Regelfall eine Rechteckspannung mit einer maximalen Amplitude zwischen 200 und 900 Volt und einer Periodendauer zwischen 20 »s und 20 ms ist. Abweichungen unter Ausbildung von nicht senkrechten Anstiegs- und Abfallflanken sowie Dachschrägen sind jedoch ebenso denkbar, sofern die Bedingung erfüllt bleibt, daß zwischen zwei maximalen Spannungswerten die Gleichspannung nicht auf Null sinkt, sondern stets oberhalb des niedrigsten Ionisierungspotentials der beteiligten Gase und unterhalb von 50 % der maximalen Spannungsauslenkung bleibt. Vorzugsweise wird ein Verhältnis der mittleren Restgleichspannung zur maximalen gepulsten Gleichspannung zwischen 0,02 und 0,5 eingestellt. Nach einer Weiterbildung des Verfahrens liegt das Verhältnis der Pulslänge (Dauer des positiven Spannungssignals eines Pulses) zu der zwischen zwei Pulsen liegenden Pulspause zwischen 0,1 bis 0,6. Die Abscheidetemperatur lag bei etwa 550 °C, so daß sich bei den eingestellten Bedingungen eine Schichtwachstumsgeschwindigkeit zwischen 0,5 bis 10 »m/h einstellte. Den schematischen Verlauf der gepulsten Gleichspannung kann man Fig. 3 entnehmen, in der mit Ug die durch das Ionisierungspotential bestimmte untere Grenzspannung bezeichnet ist. Die mittels des Plasma-Puls-CVD-Prozesses beschichteten Kreisschermesser waren weiterhin planparallel (Abweichungen < 0,003 mm) und besaßen einen Rauhigkeitswert R_{z} < 0,08 »m.

Auf einem Versuchsstand wurden Vergleichsversuche zwischen unbeschichteten Kreisschermessern mit den erfindungsgemäßen beschichteten Kreisschermessern durchgeführt. Die Schnittlänge betrug etwa 590 km. Bei den Kreisschermessern ohne Oberflächenbeschichtung kam es zu einem normalen Verlauf der Schneidenstumpfung in Abhängigkeit von der Versuchsdauer. Die zunehmende Stumpfung macht sich durch eine abnehmende Qualität der Kante des geschnittenen Magnetbandes bemerkbar. Es entstehen Wülste an der Bandkante. Mit einem Kreisschermesser, das eine Titannitridbeschichtung wie beschrieben besitzt, konnte vom Anfang bis zum Ende des Versuches eine gleichmäßige Bandkantenqualität auf sehr hohem Niveau erzielt werden. Insgesamt konnte mit diesem Kreisschermesser eine zweifache Standzeit ohne Nachschliff erzielt werden.

Das erfindungsgemäße Kreisschermesser wird beispielsweise in der in Fig. 2 dargestellten Anordnung verwendet, in der mehrere Kreisschermesser 10 auf Wellen 13 und 14 nebeneinenander befestigt sind. Die gegensinnig rotierenden Wellen (angedeutet durch Pfeile 16 und 17) schneiden ein Folienband 15 in gleichmäßig breite Streifen, die als Magnetbänder auf Träger gewickelt werden.

Fig. 3 zeigt den Verlauf der elektrischen Spannung an dem zu beschichtenden Hartmetallkorper bzw. Werkzeug.

Mit dem beschichteten Pulsplasma-CVD-Verfahren (PACVD) können aus Gasgemischen von TiCl₄, H₂, N₂ und/oder CH₄ Schichten aus TiN, TiC und Ti(C,N) einzeln oder in beliebiger Reihenfolge abgeschieden werden, z.B. als Mehrlagenbeschichtung mit der Schichtfolge TiN/Ti(C,N)/TiN auf einem Hartmetallsubstrat. Titancarbonitrid kann in jedem beliebigen Mischungsverhältnis C/N abgeschieden werden. Die typischen Eigenschaften und Zusammensetzungen von PACVD-Schichten sind in der nachfolgenden Tabelle aufgeführt:

| | TiN | Ti(C,N) | TiC |
|---|---|---|---|
| Härte HV0,05 | 2000-2400 | 2200-3400 | 3000-3400 |
| Gitterkonstante (nm) | 0,424 | 0,424-0,433 | 0,433 |

| typ. Analyse (%) | | | |
|---|---|---|---|
| Ti | 77,5 | 78,4 | 78,1 |
| N | 19,9 | 11,2 | - |
| C | - | 8,4 | 18,9 |
| O | 0,2 | 0,9 | 1,2 |
| Cl | 0,6 | 1,1 | 0,8 |

Die Schichten enthalten neben Titan, Stickstoff bzw. Kohlenstoff und Sauerstoff auch zwischen 0,5 und 4 Massen-% Chlor.

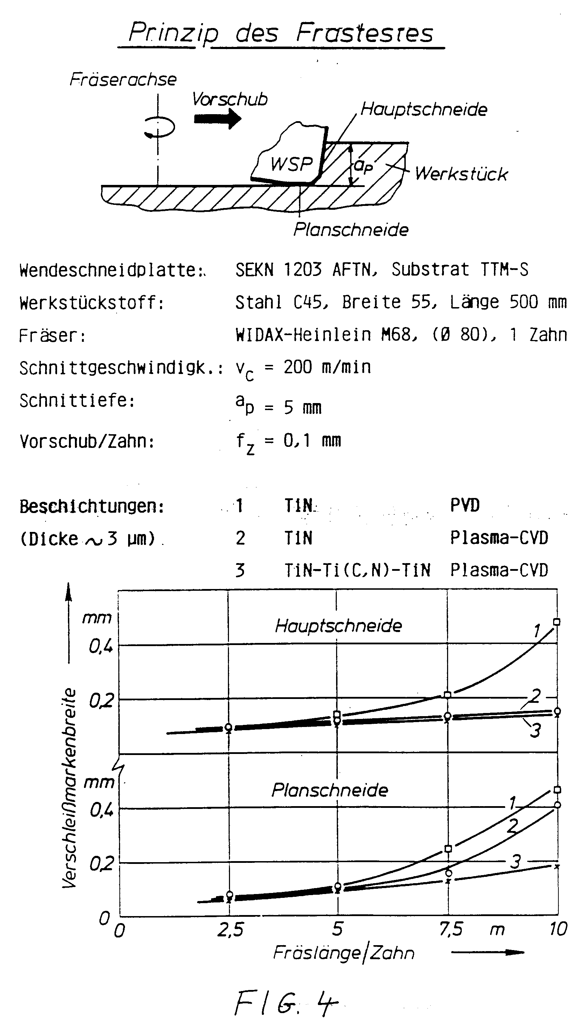

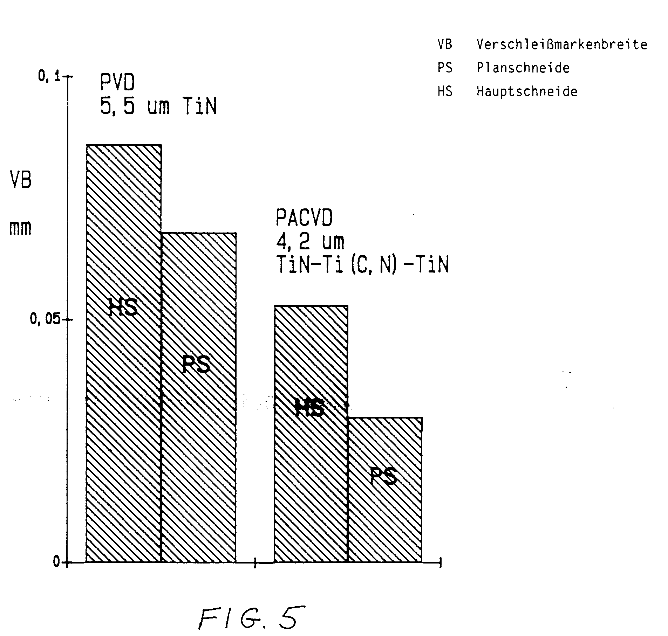

Nach dem erfindungsgemäßen Verfahren hergestellte Fräswerkzeuge zeigten hohe Standzeiten. So sind durch CVD (Chemical Vapour Deposition) mit TiC/Ti(C,N)/TiN beschichtete und durch PACVD mit 3 »m TiN beschichtete Fräsplatten SPKN 1203 EDR, mit denen Blöcke aus dem Vergütungsstahl 42CrMo4V (1000 N/mm²) gefräst wurden, miteinander vergleichen worden. Die durch CVD beschichtete Platte weist nach einem Fräsweg von 1200 mm Ausbrüche an der Hauptschneide auf, während die durch PACVD (erfindungsgemäß) beschichtete Platte nach dem doppelten Fräsweg noch schneidfähig ist. Dieser Versuch zeigt, daß durch den erfindungsgemäßen PACVD-Prozeß beschichtete Schneidkörper erheblich zäher sind. Sie haben jedoch auch Vorzüge im Vergleich zu Schneidkörpern, die durch PVD (Physical Vapour Deposition, Beschichtungstemperatur etwa 500 °C) beschichtet wurden. Letztere haben zwar auch verbesserte Zähigkeitseigenschaften) jedoch reichte die Verschleißbeständigkeit nicht an die der erfindungsgemäß beschichteten Schneidplatte heran, wie durch die beiden folgenden Untersuchungen bestätigt wird. In einem anderen Versuch wurden durch PACVD mit TiN bzw. TiN/Ti(C,N)/TiN und durch PVD mit TiN beschichtete Fräsplatten getestet. Das Prinzip und das Ergebnis des Versuches ist in Fig. 4 dargestellt. Beim Fräsen des Stahles C45 (Schnittgeschwindigkeit 200 m/min, Schnittiefe 5 mm, Vorschub/Zahn 0,1 mm) zeigt hier die härtere Mehrlagenbeschichtung insgesamt die besten Ergebnisse. PACVD-Beschichtungen weisen auch beim Fräsen von hochlegierten, austenitischen Stählen Vorteile auf, wie das in Fig. 5 dargestellte Ergebnis eines weiteren Fräsversuches (Schneidplatte: SEKN 1203 AFT, Werkstückstoff: 28NiCrMo74, 195 x 700 mm, Fräser, 6 Zähne: WIDAX M65 (80 ⌀), Schnittgeschwindigkeit: 200 m/min, Schnittiefe: 5 mm, Vorschub/Zahn 0,2 mm, Fräslänge: 14 m, Kolkverschleiß: nicht meßbar) zeigt. Bei diesen und noch weiteren Versuchen konnte festgestellt werden, daß die von PVD-Beschichtungen bekannten Standleistungen durch plasmaaktivierte CVD-Beschichtungen übertroffen werden.

Bei weiteren Fräsversuchen konnten mit nach dem erfindungsgemäßen Verfahren hergestellten Werkzeugen Standzeiten erzielt werden, die mehr als doppelt, teils sogar mehr als dreimal so lang waren wie bei nach dem Stand der Technik bekannten Fräsplatten.

Die in einem weiteren Ausführungsbeispiel abgeschiedenen Titancarbidschichten weisen ein Bruchgefüge mit einer deutlich feinkristallineren Struktur auf. Die Mikrohärte lag zwischen 3000 und 3400 HV0,05.

## Patentansprüche

1. Verfahren zur Beschichtung eines Werkzeuggrundkörpers, vorzugsweise aus Hartmetall oder Stahl, mit Carbiden, Nitriden und/oder Carbonitriden von Titan und/oder Zirkonium mittels eines Plasma-CVD-Verfahrens,
**dadurch gekennzeichnet**,
daß die Plasmaaktivierung an dem als Kathode geschalteten Werkzeuggrundkörper durch eine gepulste Gleichspannung mit einer in den Pulspausen verbleibenden Restgleichspannung einer Größe, die gleich oder größer als das niedrigste Ionisierungspotential der beteiligten Gase des CVD-Prozesses ist, maximal jedoch 50 % des maximalen Wertes der gepulsten Gleichspannung ist, durchgeführt wird.

2. Verfahren nach Anspruch 1, dadurch gekennzeichnet, daß die gepulste Gleichspannung zwischen 200 bis 900 Volt gehalten wird.

3. Verfahren nach Anspruch 1 oder 2, gekennzeichnet durch ein Verhältnis der Restgleichspannung zur maximalen gepulsten Gleichspannung zwischen 0,02 und 0,5.

4. Verfahren nach einem der Ansprüche 1 bis 3, dadurch gekennzeichnet, daß die Periodendauer der gepulsten Gleichspannung zwischen 20 »s und 20 ms eingestellt wird.

5. Verfahren nach einem der Ansprüche 1 bis 4, dadurch gekennzeichnet, daß das Verhältnis der Pulslänge zu der Pulspause zwischen 0,1 bis 0,6 liegt.

6. Verfahren nach einem der Ansprüche 1 bis 5, dadurch gekennzeichnet, daß die Schichtwachstumsgeschwindigkeit 0,5 bis 10 »m/h beträgt.

7. Verfahren nach einem der Ansprüche 1 bis 6, dadurch gekennzeichnet, daß die plasmaaktivierte CVD-Beschichtung bei Temperaturen zwischen 400 und 600°C durchgeführt wird.

8. Werkzeug, hergestellt nach den Ansprüchen 1 bis 7, bestehend aus einem Grundkörper und mindestens einer aus Carbiden, Nitriden und/oder Carbonitriden von Titan aufgebauten Oberflächenschicht₁ die mittels eines plasmaaktivierten CVD-Verfahrens unter Einsatz von Titantetrachlorid in der Gasphase aufgebracht ist, insbesondere Schneidwerkzeug mit einem Hartmetallgrundkörper und mindestens einer Oberflächenschicht, in der oder denen der Gehalt an Chlor zwischen 0,5 und 4 Massen-% liegt, wobei die Schicht(en) folgende Gitterkonstante aufweist/aufweisen:
| | |
|---|---|
| TiN: | 0.424 nm |
| Ti(C,N): | 0.424 nm - 0.433 nm |
| TiC: | 0.433 nm |

9. Werkzeug nach Anspruch 8, dadurch gekennzeichnet, daß die Oberflächenschichten eine Dicke von maximal 20 »m aufweisen.

10. Werkzeug nach Anspruch 8 oder 9, gekennzeichnet durch mehrere Oberflächenschichten in der Folge TiN-Schicht, ein oder mehrere Ti(C,N)-Schicht(en), TiN-Schicht.

11. Werkzeug nach einem der Ansprüche 8 bis 10, dadurch gekennzeichnet, daß keine der Schichten dicker als 5 »m ist.

12. Werkzeug nach einem der Ansprüche 8 bis 11, dadurch gekennzeichnet, daß der Grundkörper aus WC mit 6 bis 10 Massen-% Binder, vorzugsweise Cobalt, besteht.

13. Werkzeug nach Anspruch 12, dadurch gekennzeichnet, daß bis zu 30 Massen-% des WC durch TiC, TaC und/oder NbC ersetzt sind.

14. Werkzeug nach einem der Ansprüche 8 bis 13, zum Schneiden von Magnetbändern aus Kunststoff, wie Polyester, der mit einer Schicht aus Eisenoxid und/oder Chromoxid beschichtet und zum Einspeichern von Ton- oder Videosignalen geeignet ist, dadurch gekennzeichnet, daß das Werkzeug als Kreisschermesser ausgebildet ist und aus einem ringförmigen flachen Hartmetallkörper (11) besteht, der mit mindestens einer aus Carbiden, Nitriden und/oder Carbonitriden des Titans bestehenden, gleichmäßig planparallelen Oberflächenschicht (12) einer Dicke (d1) zwischen 1 bis 4 »m überzogen ist, wobei die Abweichung von der Planparallelität der Oberflächenschicht < 0,003 mm und/oder die Rauhigkeit R_{Z} < 0,08 »m betragen.

15. Werkzeug nach Anspruch 14, dadurch gekennzeichnet, daß die Oberflächenschicht (d1) 2 bis 3 »m dick ist.

16. Werkzeug nach Anspruch 14 bis 15, dadurch gekennzeichnet, daß der Hartmetallkörper (11) zwischen 0,4 mm und 0,8 mm, vorzugsweise zwischen 0,5 mm und 0,6 mm, dick ist.

17. Werkzeug nach einem der Ansprüche 14 bis 16, dadurch gekennzeichnet, daß der Hartmetallkörper (11) einen Außendurchmesser (D) zwischen 80 und 150 mm, vorzugsweise zwischen 100 und 125 mm, und/oder eine zentrale Bohrung mit einem Durchmesser (d) von 50 bis 80 mm, vorzugsweise 60 bis 70 mm, aufweist.

18. Werkzeug nach einem der Ansprüche 14 bis 17, dadurch gekennzeichnet, daß der Hartmetallkörper (11) im wesentlichen aus WC mit 6 bis 25 Massen-%, vorzugsweise 9 bis 15 Massen-% Cobalt als Binder besteht.

## Claims

1. Process for coating a basic tool body, preferably of hard metal or of steel, with carbides, nitrides and or carbonitrides of titanium and/or zirconium by means of a plasma-CVD process, characterized in that the plasma activation is generated at the basic tool body set up to function as a cathode, by a pulsed direct-current voltage with a residual direct-current voltage maintaining during puls pauses and having a magnitude which is equal to or higher than the lowest ionization potential of the gas molecules participating in the CVD-process, but does not exceed 50 % of the maximum value of the pulsed direct-current voltage.

2. Process according to claim 1, characterized in that the pulsed direct-current voltage is hold between 200 to 900 volts.

3. Process according to claim 1 or 2, characterized in a ratio of the residual direct-current voltage to the maximum voltage of the pulsed direct-current voltage between 0.02 to 0.5.

4. Process according to one of the claims 1 to 3, characterized in that the duration period of the pulsed direct-current voltage is adjusted between 20 »m to 20 ms.

5. Process according to one of the claims 1 to 4, characterized in that the ratio of the pulse length to the pulse pause ranges from 0.1 to 0.6.

6. Process according to one of the claims 1 to 5, characterized in that the surface layer growth rate ranges from 0.5 to 10 »m/h.

7. Process according to one of the claims 1 to 6, characterized in that the plasma-activated CVD-coating is effected at temperatures between 400 to 800°C.

8. A tool manufactured according to claims 1 to 7, having a basic body and at least one surface layer comprised of at least one hard substance of carbides, nitrides and/or carbonitrides of titanium, being produced by a plasma-activated CVD-process using titaniumtetrachloride in the gas phase in particular a cutting tool having a basic hard metal body and at least one surface layer, in which the content of chlorine lies between 0.5 and 4 mass percent, whereby the surface layer(s) has/have following lattice parameter:
| | |
|---|---|
| TiN | 0.424 nm |
| Ti(C,N) | 0.424 nm - 0.433 nm |
| TiC | 0.433 nm. |

9. The tool according to claim 8, characterized in that the surface layers have a thickness which does not exceed 20 »m.

10. The tool according to claim 8 or 9, characterized in several surface layers in a sequence of a TiN layer, one or a plurality of Ti(C,N) layers, and a TiN layer.

11. The tool according to one of the claims 8 to 10, characterized in that no layer has a thickness which exceeds 5 »m.

12. The tool according to one of the claims 8 to 11, characterized in that the basic tool body comprises WC and from 6 to 10 mass percent of a binder, preferably cobalt.

13. The tool according to claim 12, characterized in that up to 30 mass percent of WC is replaced by TiC, TaC and/or NbC.

14. The tool according to one of the claims 8 to 13 for cutting magnetic tapes of plastic as polyester, which is coated with at least one layer of ferric oxide or chrome oxide and appropriated to storage of audio or video signals, characterized in that the tool is formed as a circular shearing blade and comprising of a hard metal body (11) which is annular and flat, and which is coated with at least one surface layer (12) of carbides, nitrides and/or carbonitrides of titanium, being uniformly plane parallel, having a thickness (d₁) ranging from 1 to 4 »m, whereby the deviation from plane parallelism is <0.003 mm and/or a roughness (R_{Z}) <0.08 »m.

15. Tool according to claim 14, characterized in that the surface layer (d₁) is 2 to 3 »m thick.

16. Tool according to claim 14 or 15, characterized in that the hard metal body (11) has a thickness ranging from 0.4 to 0.8 mm, preferably between 0.5 mm and 0.6 mm.

17. The process according to one of the claims 14 to 16, characterized in that the hard metal body (11) has an external diameter (D) ranging from 80 to 150 mm, preferably from 100 to 125 mm, and /or a central bore having a diameter (d) ranging from 50 to 80 mm, preferably from 60 to 70 mm.

18. The process according to one of the claims 14 to 17, characterized in that the hard metal body (11) comprises essentially WC and from 6 to 25 mass percent, preferably from 9 to 15 mass percent, of cobalt as a binder.

## Revendications

1. Procédé de revêtement d'un outil, de préférence en métal dur ou en acier, avec des carbures, des nitrures et / ou des carbonitrures du titane et / ou du zirconium par le biais d'un procédé CVD de plasma,
**caractérisé par le fait**
que l'activation par plasma sur l'outil utilisé en tant que cathode est effectuée par l'intermédiaire d'une tension continue pulsée avec une tension continue résiduelle maintenue durant les intervalles entre impulsions, dont la valeur est égale ou supérieure au potentiel d'ionisation le plus faible des gaz participant au processus CVD, mais qui est au maximum égale à 50 % de la valeur maximale de la tension continue pulsée

2. Procédé selon la revendication 1, caractérisé par le fait que la tension continue pulsée est tenue entre 200 et 900 Volt.

3. Procédé selon la revendication 1 ou 2, caractérisé par le fait que le rapport de la tension continue résiduelle à la tension continue pulsée maximale est compris entre 0,02 et 0,5.

4. Procédé selon l'une des revendications 1 à 3, caractérisé par le fait que la durée de période de la tension continue pulsée est reglée entre 20 »s et 20 ms.

5. Procédé selon l'une des revendications 1 à 4, caractérisé par le fait que le rapport de la durée d'impulsion à la durée d'intervalles entre impulsions est compris entre 0,1 et 0,6.

6. Procédé selon l'une des revendications 1 à 5, caractérisé par le fait que la vitesse de croissance des couches est comprise entre 0,5 et 10 »m/h.

7. Procédé selon l'une des revendications 1 à 6, caractérisé par le fait que le revêtement CVD activé par plasma est réalisé à des températures comprises entre 400 et 600 °C.

8. Outil fabriqué selon les revendications 1 à 7, composé d'un corps de base et du moins une couche superficielle formée de carbures, de nitrures et / ou de carbonitrures du titane, qui est appliquée par le biais d'un procédé CVD activé par plasma, dans la phase gazeuse, en utilisant du tétrachlorure de titane, en particulier outil de coupe avec un corps de base en métal dur et du moins une couche superficielle, dans laquelle ou bien dans lesquelles la teneur en chlore est comprise entre 0,5 et 4 pour cent de masse, la couche ou bien les couches présentant la constante de réseau suivante:
| | |
|---|---|
| TiN: | 0.424 nm |
| Ti(C,N): | 0.424 nm - 0.433 nm |
| TiC: | 0.433 nm |

9. Outil selon la revendication 8, caractérisé par le fait que les couches superficielles présentent une épaisseur de 20 »m au maximum.

10. Outil selon la revendication 8 ou 9, caractérisé par plusieurs couches superficielles disposées dans la suite: couche en TiN, une couche ou plusieurs couches en Ti (C, N), couche en TiN.

11. Outil selon l'une des revendications 8 à 10, caractérisé par le fait qu'aucune des couches ne présente une épaisseur de plus de 5 »m.

12. Outil selon l'une des revendications 8 à 11, caractérisé par le fait que le corps de base se compose de WC avec 6 à 10 pour cent de masse de liant, de préférence du cobalt.

13. Outil selon la revendication 12, caractérisé par le fait que jusqu'à 30 pour cent de masse du WC sont remplacés par du TiC, TaC et / ou du NbC.

14. Outil selon l'une des revendications 8 à 13, servant à couper des bandes magnétiques en matière synthétique tel que du polyester, qui est revêtue d'une couche en oxyde de fer et /ou en oxyde de chrome et qui se prête à la mémorisation de signaux audio ou vidéo, caractérisé par le fait que l'outil est réalisé en tant qu'outil à cisailler circulaire et qu'il est composé d'un corps en métal dur plat et annulaire (11), qui est revêtu au moins d'une couche superficielle (12) à faces uniformément planes et parallèles, composée de carbures, de nitrures et / ou de carbonitrures du titane et présentant une épaisseur (d1) comprise entre 1 et 4 »m, l'écart du parallélisme exact des faces de la couche superficielle étant < 0,003 mm et / ou la rugosité R_{Z} étant < 0,08 »m.

15. Outil selon la revendication 14, caractérisé par le fait que la couche superficielle (d1) présente une épaisseur comprise entre 2 et 3 »m.

16. Outil selon la revendication 14 à 15, caractérisé par le fait que le corps en métal dur (11) présente une épaisseur comprise entre 0,4 mm et 0,8 mm, et de préférence entre 0,5 mm et 0,6 mm.

17. Outil selon l'une des revendications 14 à 16, caractérisé par le fait que le corps en métal dur (11) présente un diamètre extérieur (D) compris entre 80 et 150 mm, et de préférence entre 100 et 125 mm, et / ou un alésage central présentant un diamètre (d) de 50 à 80 mm, et de préférence de 60 à 70 mm.

18. Outil selon lune des revendications 14 à 17, caractérisé par le fait que le corps en inétal dur (11) se compose pour l'essentiel de WC avec 6 à 25 pour cent de masse, et de préférence avec 9 à 15 pour cent de masse de cobalt en tant que liant.
